# EUROPÄISCHE PATENTSCHRIFT

(11) **EP 1 532 733 B1**
(45) Veröffentlichungstag und Bekanntmachung des Hinweises auf die Patenterteilung: **05.03.2008**
(21) Anmeldenummer: 03747811.2
(22) Anmeldetag: 20.08.2003
(51) Int. Cl.: H03F 3/72, H04B 1/48

(54) **EMPFANGSANORDNUNG MIT VORVERSTÄRKERSCHALTUNG**
RECEIVING ARRANGEMENT COMPRISING A PRE-AMPLIFIER CIRCUIT
ENSEMBLE RECEPTEUR A CIRCUIT PREAMPLIFICATEUR

(30) Priorität: 29.08.2002 DE 10239854
(43) Veröffentlichungstag der Anmeldung: 25.05.2005
(73) Patentinhaber: Infineon Technologies AG, 81669 München (DE)
(72) Erfinder: SCHMIDT, Axel, 31515 Wunstorf (DE)
(74) Vertreter: Epping - Hermann - Fischer
(86) Internationale Anmeldenummer: PCT/DE2003/002773
(87) Internationale Veröffentlichungsnummer: WO 2004/021563

(56) Entgegenhaltungen:
- WO-A-02/15397
- GB-A- 2 277 650

## Beschreibung

Die vorliegende Erfindung betrifft eine Empfangsanordnung mit Vorverstärkerschaltung.

In Hochfrequenzanwendungen, beispielsweise im Mobilfunk, werden normalerweise am Eingang der Signalverarbeitungskette eines Empfängers rauscharme Vorverstärker eingesetzt. Rauscharme Vorverstärker werden auch als LNA, Low Noise Amplifier, bezeichnet. Derartige rauscharme Vorverstärker bewirken bei geringem Rauschbeitrag einen ausreichend hohen Signal-Rausch-Abstand für nachfolgende Signalverarbeitungsblöcke.

Hochfrequenzempfänger mit einem derartigen LNA sind normalerweise durch Ergänzen mit einem Sendezweig zu sogenannten Transceivern oder Sendeempfängern weitergebildet. Somit ist ein bidirektionales Übertragen von Daten, beispielsweise von Sprachdaten möglich.

Gemäß Mobilfunkstandard GSM, Global System for Mobile communication beispielsweise erfolgen Senden und Empfangen abwechselnd. Da dieses abwechselnde Senden und Empfangen aber für den Benutzer unmerklich geschieht, spricht man bei GSM-Mobilfunkgeräten dennoch von vollduplexfähigen Systemen.

Wenn in einem derartigen Transceiver bei aktivem Sendezweig eine Nutzdatenübertragung stattfindet, so ist sicherzustellen, daß am Eingang des ausgeschalteten Empfangszweiges keine zu große Eingangsleistung anliegt. Diese könnte zum einen zu Störsignalen im Sendespektrum, zum anderen aber auch zur vorzeitigen Alterung bis hin zur Zerstörung der nichtaktiven Eingangstransistoren des rauscharmen Vorverstärkers im Empfänger führen. Die Eingangstransistoren der nichtaktiven Verstärker sind deswegen bei inaktivem Empfänger ausgeschaltet, da sie nicht benötigt werden und darüber hinaus der Stromverbrauch derartiger Transceiver normalerweise eine wichtige Rolle spielt, besonders bei einem Einsatz im Mobilfunk.

Eine Möglichkeit, eine ausreichende Dämpfung des Sendespektrums bezüglich der Eingänge des Vorverstärkers im Empfangszweig zu gewährleisten, ist, dem Vorverstärker externe Oberflächenwellenfilter vorzuschalten. Diese Oberflächenwellenfilter sind oftmals ohnehin vorhanden, um eine ausreichende Kanalselektion im Empfangszweig sicherzustellen.

Externe Oberflächenwellenfilter stellen jedoch einen verhältnismäßig hohen Aufwand bei ansonsten weitgehend in integrierter Schaltungstechnik aufgebauten Sendeempfangseinheiten dar, so daß auch bei Verzicht auf einzelne externe SAW-Filter eine ausreichend gute Isolation des Empfangspfades von einem aktiven Sendepfad gewünscht ist. Ziel ist, Chipmodule verwenden zu können, in denen mehrere SAW-Filter integriert sind.

GB2277650 offenbart einen Sender/Empfänger mit Schaltbaren Verstärkern.

Aufgabe der vorliegenden Erfindung ist es, eine Empfangsanordnung mit Vorverstärkerschaltung anzugeben, welche bei verringerter Anzahl von Bauteilen eine vorzeitige Alterung oder Zerstörung nicht aktiver Transistoren im Vorverstärker der Empfangssignalkette durch Störsignale vermeidet.

Erfindungsgemäß wird die Aufgabe durch eine Empfangsanordnung mit den Merkmalen des Patentanspruchs 1 gelöst.

Der Vorverstärker, der besonders zum Einsatz in Empfangspfaden von Mobilfunkgeräten geeignet ist, verstärkt mittels zumindest eines Transistors ein an seinem Signaleingang zuführbares, hochfrequentes Nutzsignal. Dieses verstärkte, vom Nutzsignal abgeleitete Signal wird am Signalausgang des Transistors bereitgestellt. Der Schalter koppelt mit seinem ersten und seinem zweiten Anschluß den Signaleingang des Transistors mit einem Bezugspotentialanschluß.

Der Schalter wird Während eines inaktiven Zustands des Vorverstärkers geschlossen. Der inaktive Zustand ist dabei insbesondere dadurch festgelegt, daß kein Nutzsignal empfangen beziehungsweise zu verstärken ist. Bei einem normalen Nutzsignal-Empfangsbetrieb des Verstärkers hingegen ist der Schalter am Signaleingang des Transistors geöffnet.

Durch Schließen des Schalters wird der Nutzsignaleingang des Transistors und damit des Vorverstärkers insgesamt auf Bezugspotential gelegt. Der Signaleingang wird demnach niederohmig. Wenn nun ein Störsignal mit gegebenenfalls hoher Leistung am Eingang des Vorverstärkers anliegt, so führt diese hohe Leistung aufgrund der Niederohmigkeit des Eingangs lediglich zu einem sehr geringen Spannungshub. Somit wird vorteilhafterweise gewährleistet, daß der Transistor im Vorverstärker eines inaktiven Empfangspfades nicht durch Störsignale vorzeitig altert. Außerdem tritt keine Verschlechterung des Sendespektrums auf.

Als Bezugspotentiale können dabei nicht nur Massepotential, sondern auch andere Referenzpotentiale in Frage kommen und verwendet werden.

Da der Vorverstärker somit in einfacher Weise vor Störsignalen auch hoher Leistung geschützt ist, kann gemäß dem vorliegenden Prinzip auf dem Vorverstärker vorgeschaltete, einzelne externe Oberflächenwellenfilter verzichtet werden. Beispielsweise können nunmehr anstelle einzelner externer Oberflächenwellenfilter sogenannte Filtermodule eingesetzt werden, in denen mehrere SAW-Filter integriert sind und die eine geringere Dämpfung als einzelne externe Oberflächenwellenfilter aufweisen. Insbesondere können gemäß vorliegendem Prinzip ohne Nachteile Empfangsanordnungen mit einer deutlich verringerten Anzahl von erforderlichen Bauteilen beziehungsweise Chips und damit kostengünstiger hergestellt werden.

Gemäß einer bevorzugten Weiterbildung der Erfindung ist der Vorverstärker als symmetrischer Verstärker ausgebildet. Dabei ist ein erster und ein zweiter Transistor vorgesehen, mit je einem Eingangsanschluß, die gemeinsam einen symmetrischen Signaleingang zum Zuführen eines differentiellen, hochfrequenten Nutzsignals bilden. Die Ausgangsanschlüsse von erstem und zweitem Transistor bilden den symmetrischen Signalausgang. Erster und zweiter Transistor sind bevorzugt miteinander, beispielsweise an je einem dritten Anschluß der Transistoren verkoppelt.

Bei Ausführung der Transistoren als Bipolartransistoren, welche den Vorteil besonders guter Hochfrequenzeigenschaften haben, ist bevorzugt ein gemeinsamer Emitterknoten gebildet.

Der gemäß vorliegendem Prinzip vorgesehene Schalter zum Verbinden des Signaleingangs mit Bezugspotential und damit zum niederohmig Schalten des Signaleingangs ist bevorzugt so ausgeführt, daß jedem verstärkenden Transistor je ein Schalter zugeordnet ist, der den jeweiligen Eingangsanschluß auf Bezugspotential legt, wenn sich der Vorverstärker in einem inaktiven Zustand befindet.

Bevorzugt ist ein Mittel zum Aktivieren oder Einschalten des Vorverstärkers vorgesehen.

Das Mittel zum Aktivieren des Vorverstärkers umfaßt bevorzugt einen weiteren Schalter.

Dabei wird bevorzugt, beispielsweise mittels einer Steuerschaltung, der erste und der zweite Schalter gerade dann geöffnet, wenn mit dem Mittel zum Aktivieren des Vorverstärkers dieser aktiviert, das heißt eingeschaltet wird und umgekehrt.

Der oder die Transistoren des rauscharmen Vorverstärkers sind bevorzugt als Bipolartransistoren ausgebildet. Alternativ kann die Schaltung jedoch auch in Complementary Metal Oxide Semiconductor Schaltungstechnik integriert werden.

Bezüglich der Empfangsanordnung wird die Aufgabe gelöst durch eine Empfangsanordnung mit einer Vorverstärkerschaltung wie vorstehend beschrieben, wobei die Empfangsanordnung umfaßt:
- ein Mittel zum Einkoppeln eines hochfrequenten Signals,
- ein Bandpaßfilter mit einem Eingang, der mit dem Mittel zum Einkoppeln eines hochfrequenten Signals gekoppelt ist, und mit einem Ausgang,
- die Vorverstärkerschaltung mit dem Signaleingang, der an den Ausgang des Bandpaßfilters angeschlossen ist,
- einen Abwärts-Frequenzmischer mit einem Nutzsignaleingang, der mit dem Signalausgang des Vorverstärkers gekoppelt ist, mit einem Lokaloszillatorsignaleingang und mit einem Ausgang zum Abgreifen eines abwärtsgemischten Signals und
- einen Steuereingang, der mit dem Steuereingang des Vorverstärkers gekoppelt ist, zum Schließen des Schalters zwischen Signaleingang des Transistors und Bezugspotential, wenn kein Nutzsignal empfangen wird.

Insbesondere bei nicht aktivem Receive-Pfad liegt durch Verkopplung des Sendepfades mit dem Empfangspfad über eine Duplexeinheit eine verhältnismäßig große Eingangsleistung in Form eines Störsignals am Eingang der Empfangssignalkette an.

Da jedoch gemäß dem vorliegenden Prinzip mittels des Schalters am Signaleingang des Transistors im Vorverstärker dieser Signaleingang des Vorverstärkers niederohmig ist, während der Vorverstärker nicht aktiv ist, führt die hohe Leistung des Eingangssignals lediglich zu einem sehr geringen Spannungshub.

Somit ist gewährleistet, daß keine Verkopplung mit dem Transmitpfad auftreten kann. Folglich können Eingangstransistoren im Vorverstärker sowie nachgeschaltete Bauteile nicht durch vorzeitige Alterung beschädigt werden.

Ein weiterer Vorteil ergibt sich bei der Anwendung des beschriebenen Prinzips in Transceivern mit zwei oder mehr Empfangszweigen. Derartige Multimode-Empfänger können beispielsweise in einem Empfangspfad für Phasen- und Frequenzmodulation und in einem weiteren Empfangspfad für Amplitudenmodulation ausgelegt sein. Gemäß dem vorgeschlagenen Prinzip ist die Isolation zwischen einem aktiven und einem nicht aktiven Empfangspfad deutlich erhöht. Bei zu niedriger Isolation zwischen zwei Empfangspfaden, von denen nur einer in Betrieb ist, hingegen wäre in unerwünschter Weise die Großsignalfestigkeit des jeweils aktiven Pfades reduziert, was vorliegend mit Erfolg vermieden wird.

Insbesondere können mit dem vorliegenden Prinzip anstelle von dem Vorverstärker vorgeschalteten externen Surface Acoustic Wave-Filtern auch integrierte Filter oder Modulfilter mit geringerer Dämpfung verwendet werden.

Zwischen den Ausgangsanschlüssen der Vorverstärkertransistoren und dem Hochfrequenzmischer kann je ein Kaskodetransistor zur Bildung einer Kaskodeschaltung vorgesehen sein. Hierdurch wird eine weitere Erhöhung der Isolation erzielt.

Zwischen den rauscharmen Vorverstärker und den Mischer kann eine zusätzliche Verstärkerstufe eingeschaltet sein.

Weitere Einzelheiten und vorteilhafte Ausgestaltungen der vorliegenden Erfindung sind Gegenstand der Unteransprüche.

Die Erfindung wird nachfolgend an mehreren Ausführungsbeispielen,anhand der Zeichnungen näher erläutert.

Es zeigen:
- Figur 1: einen Schaltplan eines beispielhaften Vorverstärkers mit nachgeschaltetem Hochfrequenzmischer und
- Figur 2: ein Anwendungsbeispiel des Vorverstärkers von Figur 1 im Empfangszweig eines schematisch dargestellten Mobilfunk-Transceivers.

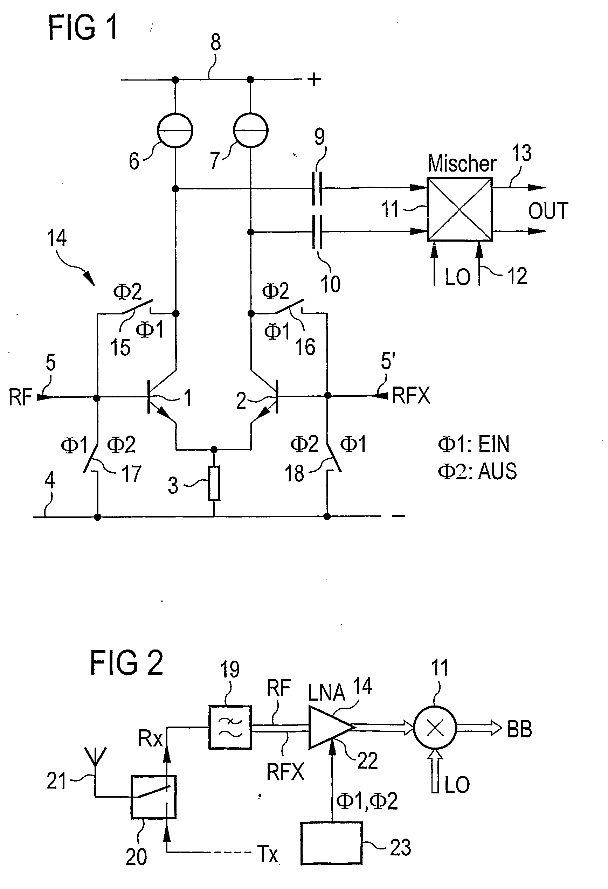

Figur 1 zeigt eine Vorverstärkerschaltung mit symmetrischem Aufbau, die in bipolarer Schaltungstechnik realisiert ist. Die Vorverstärkerschaltung umfaßt einen ersten und einen zweiten Bipolartransistor, die zur Bildung eines Differenzverstärkers emitterseitig miteinander gekoppelt sind. Erster und zweiter Transistor 1, 2 sind mit ihrem gemeinsamen Emitterknoten über einen Widerstand 3 mit einem Bezugspotentialanschluß 4 verbunden. Die beiden Basisanschlüsse der Transistoren 1, 2 bilden den Signaleingang 5, 5' der Transistoren 1, 2 und damit auch den Signaleingang des Vorverstärkers. Die Kollektoranschlüsse der Transistoren 1, 2 sind über je eine Stromquelle 6, 7 an einem Versorgungspotentialanschluß 8 angeschlossen. Die Kollektoranschlüsse der Transistoren 1, 2 bilden zugleich den Signalausgang des Vorverstärkers zum Bereitstellen eines verstärkten, vom Nutzsignal abgeleiteten Signal und sind über je eine Koppelkapazität 9, 10 an den symmetrischen Eingang eines Hochfrequenz-Abwärtsmischers 11 angeschlossen.

Der Hochfrequenz-Abwärtsmischer 11 hat weiterhin einen symmetrischen Lokaloszillatorsignal-Eingang 12 und einen Ausgang 13, an dem ein abwärtsgemischtes Signal bereitgestellt wird. Der Vorverstärker 1 bis 8, der vorliegend mit Bezugszeichen 14 versehen ist, dient zum Vorverstärken eines hochfrequenten, symmetrischen Signals.

Zum Einschalten des Vorverstärkers ist ein Schalterpaar 15, 16 vorgesehen. Der Schalter 15 verbindet den Basisanschluß des ersten Transistors 1 mit dessen Kollektoranschluß. Der Schalter 16 verbindet den Basisanschluß des zweiten Transistors 2 mit dessen Kollektoranschluß. Die Schalter 15, 16 werden jeweils gleichzeitig ein- und ausgeschaltet. Der eingeschaltete Zustand der Schalter 15, 16 ist mit Φ1, der ausgeschaltete Zustand mit Φ2 bezeichnet. Ein Schließen der Schalter 15, 16 bewirkt demnach ein Einschalten des Vorverstärkers. Durch Öffnen der Schalter 15, 16 wird der Vorverstärker ausgeschaltet. Die Ansteuerung der Schalter 15, 16 erfolgt bevorzugt über eine hier nicht dargestellte Steuereinheit in Abhängigkeit von dem Anliegen eines zu verstärkenden, hochfrequenten Nutzsignals.

Zusätzlich zu den Schaltern 15, 16 ist ein Schalterpaar 17, 18 vorgesehen zum Niederohmigschalten der Eingangsklemmen 5, 5' dann, wenn der Vorverstärker inaktiv beziehungsweise ausgeschaltet ist. Die Schalter 17, 18 verbinden die Eingangsklemmen 5, 5' jeweils zu- und abschaltbar mit Bezugspotentialanschluß 4. Während sich der Vorverstärker 14 in einem eingeschaltetem Zustand Φ1 befindet, sind die Schalter 17, 18 geöffnet. Ist der Vorverstärker jedoch im ausgeschalteten Zustand Φ2, so sind die Schalter 17, 18 geschlossen und damit die Eingänge 5, 5' niederohmig.

Auf Grund der sehr niederohmigen Eingangsimpedanz der Eingänge des nicht aktiven Vorverstärkers führt eine eventuell anliegende hohe Signalleistung an diesem Eingang zu einem lediglich geringen Spannungshub. Hierdurch wird vermieden, daß die Eingangstransistoren 1, 2 des Vorverstärkers sowie nachgeschaltete Baugruppen zerstört oder beschädigt werden oder in einen unerwünschten Zustand gehen.

Eingangsseitig am Vorverstärker können nun Filter mit geringerer Dämpfung eingesetzt werden, da die ausreichende Unterdrückung von Störsignalen im Vorverstärker selbst geschehen kann.

Die Ansteuerung der Schalter 15 bis 18 in eingeschaltetem und ausgeschaltetem Zustand Φ1, Φ2 ist gerade gegenläufig eingezeichnet und beschrieben, das heißt, daß die Schalter 17, 18 geschlossen sind, wenn die Schalter 15, 16 geöffnet sind und umgekehrt. Es kann jedoch anwendungsabhängig und im Rahmen der Erfindung sinnvoll sein, bestimmte Nichtüberlappungszeiten der Schalter einzuhalten, um beispielsweise sicherzustellen, daß zu keiner Zeit alle Schalter geschlossen oder alle Schalter geöffnet sind, je nach Anforderungen der Anwendung und den Eigenschaften der verwendeten Bauteile.

Figur 2 zeigt eine beispielhafte Anwendung des Vorverstärkers 14 als rauscharmer Vorverstärker in der Empfangssignalkette Rx eines Mobilfunk-Transceivers. Wie in Figur 1 ist dem rauscharmen Vorverstärker 14 ein Abwärts-Frequenz-Mischer 11 nachgeschaltet, der ein vorverstärktes, empfangenes Hochfrequenzsignal RF unter Zuhilfenahme eines Trägersignals oder Lokaloszillatorsignals LO in ein Basisbandsignal BB oder ein Zwischenfrequenzsignal umsetzt. Eingangsseitig am Vorverstärker 14 ist ein Bandpaßfilter 19 angeschlossen, welches in alternativen Ausführungsformen auch als Bandpaßfilter weitergebildet sein kann. Das Filter 19 ist als Oberflächenwellenfilter oder SAW-Filter ausgeführt. Der Eingang des SAW-Filters 19 ist an eine Duplexeinheit 20 angeschlossen, die den Empfangspfad Rx, einen Sendepfad Tx sowie eine Antenne 21 miteinander verkoppelt. An den Steuereingang 22 des rauscharmen Vorverstärkers 14 ist eine Steuerschaltung 23 angeschlossen ausgelegt zum Umschalten zwischen eingeschaltetem Zustand Φ1 und ausgeschaltetem Zustand Φ2 des Vorverstärkers 14.

Wenn der Sendepfad Tx im Transceiver aktiv ist, so können an der Duplexeinheit 20 hohe Signalpegel anliegen, welche, je nach Ausführung der Duplexeinheit als Schalter oder Filteranordnung, als relativ hoher Signalpegel im Empfangspfad durchscheinen können. Auf Grund der dem vorliegenden Prinzip eigenen Absicherung der Eingänge des Vorverstärkers 14 mittels der Schalter 17, 18 mit niederohmiger Eingangsimpedanz kann mit Vorteil ein Oberflächenwellenfilter 19 oder ein anderes Filter mit geringerer Dämpfung und Signalselektion verwendet werden.

Somit können gemäß vorliegendem Prinzip anstelle externer Oberflächenwellenfilter mit hoher Signalselektion und hoher Dämpfung auch integrierte Oberflächenwellenfilter oder Modulfilter mit geringerer Dämpfung und geringerem Aufwand verwendet werden.

Insgesamt ist gewährleistet, daß keine Verkoppelung des Empfangspfades mit dem Sendepfad auftreten kann und Eingangstransistoren des gerade nicht aktiven Empfangspfades nicht zerstört werden können.

Das vorliegende Prinzip ist dabei mit besonders geringem Aufwand realisierbar, da der Vorverstärker 14 um lediglich 2 Schalter 17, 18 zu ergänzen ist. Die Schalter 17, 18 können dabei beispielsweise als Transistorschalter ausgeführt werden.

Weiterhin liegt es selbstverständlich im Rahmen der Erfindung, den beschriebenen Vorverstärker mit in einen niederohmigen Zustand schaltbarem Signaleingang auch auf andere Baugruppen anstelle von Hochfrequenzmischern anzuwenden.

### Bezugszeichenliste

- 1: Transistor
- 2: Transistor
- 3: Widerstand
- 4: Bezugspotentialanschluß
- 5: Eingang
- 5': Eingang
- 6: Stromquelle
- 7: Stromquelle
- 8: Versorgungspotentialanschluß
- 9: Kondensator
- 10: Kondensator
- 11: Abwärts-Mischer
- 12: Lokaloszillatoreingang
- 13: Ausgang
- 14: Vorverstärker
- 15: Schalter
- 16: Schalter
- 17: Schalter
- 18: Schalter
- 19: Oberflächenwellenfilter
- 20: Duplexeinheit
- 21: Antenne
- 22: Steuereingang
- 23: Steuerschaltung
- Φ1: eingeschalteter Zustand
- Φ2: ausgeschalteter Zustand
- BB: Basisband-Signal
- LNA: rauscharmer Vorverstärker
- LO: Lokaloszillatorsignal
- OUT: Ausgangssignal
- RF: Hochfrequenz-Signal
- RFX: Hochfrequenz-Signal
- RX: Empfangspfad
- TX: Sendepfad

## Patentansprüche

1. Empfangsanordnung mit Vorverstärkerschaltung umfassend
- ein Mittel zum Einkoppeln (21) eines hochfrequenten Signals,
- die Vorverstärkerschaltung (14), umfassend einen Vorverstärker (14) mit einem Transistor (1), aufweisend einen Signaleingang (5) an dem Transistor (1) zum Zuführen eines hochfrequenten Nutzsignals (RF), der mit dem Mittel zum Einkoppeln (21) eines hochfrequenten Signals gekoppelt ist, einen Signalausgang an dem Transistor (1) zum Bereitstellen eines verstärkten, vom Nutzsignal abgeleiteten Signals und einen Schalter (17), mit einem ersten Anschluß, der an den Signaleingang (5) angeschlossen ist, mit einem zweiten Anschluß, der mit einem Bezugspotentialanschluß (4) verbunden ist, und mit einem Steuereingang zum Schließen des Schalters (17) während eines inaktiven Zustands (Φ2) des Vorverstärkers (14),
- einen Abwärts-Frequenzmischer (11) mit einem Nutzsignaleingang, der mit dem Signalausgang des Vorverstärkers (14) gekoppelt ist, mit einem Lokaloszillatorsignaleingang und mit einem Ausgang (OUT) zum Abgreifen eines abwärtsgemischten Signals (BB) und
- einen Steuereingang (22), der mit dem Steuereingang des Vorverstärkers gekoppelt ist, zum Schließen des Schalters (17) zwischen Signaleingang (5) des Transistors (1) und Bezugspotential (4), wenn kein Nutzsignal empfangen wird (Φ2).

2. Empfangsanordnung nach Anspruch 1,
**dadurch gekennzeichnet, daß**
der Vorverstärker (14) zusätzlich zu dem als ersten Transistor ausgebildeten Transistor (1) einen zweiten Transistor (2) umfaßt, der zur Bildung eines symmetrischen Verstärkers mit dem ersten Transistor (1) gekoppelt ist und dessen Eingangsanschluß (5') und Ausgangsanschluß jeweils mit dem Signaleingang (5) und dem Signalausgang des ersten Transistors (1) einen symmetrischen Signaleingang (5, 5') und einen symmetrischen Signalausgang bildet, und daß
zusätzlich zu dem als ersten Schalter (17) ausgeführten Schalter ein zweiter Schalter (18) vorgesehen ist, mit einem ersten Anschluß, der an den Signaleingang (5') des symmetrischen Verstärkers angeschlossen ist, mit einem zweiten Anschluß, der mit dem Bezugspotentialanschluß (4) verbunden ist, und mit einem Steuereingang zum Schließen des zweiten Schalters während des inaktiven Zustands (Φ2) des Vorverstärkers (14).

3. Empfangsanordnung nach Anspruch 1 oder 2,
**dadurch gekennzeichnet, daß**
ein Mittel zum Aktivieren (15) des Vorverstärkers (14) vorgesehen ist.

4. Empfangsanordnung nach einem der Ansprüche 1 bis 3,
**dadurch gekennzeichnet, daß**
der Signaleingang (5) des Transistors (1) dessen Basis- oder Gate-Anschluß ist.

5. Empfangsanordnung nach Anspruch 3 und 4,
**dadurch gekennzeichnet, daß**
das Mittel zum Aktivieren (15) des Vorverstärkers als Schalter zwischen Basis- und Kollektoranschluß oder zwischen Gate- und Drainanschluß des Transistors (1) ausgeführt ist.

6. Empfangsanordnung nach einem der Ansprüche 1 bis 5,
**dadurch gekennzeichnet, daß**
eine Duplexeinheit (20) vorgesehen ist, mit einem Ausgang, der mit dem Eingang eines Bandpaßfilters (19) gekoppelt ist, mit einem Eingang, an den ein Sendepfad (Tx) zum Senden eines hochfrequenten Signals angeschlossen ist und mit einem Anschluß, der mit dem Mittel zum Einkoppeln (21) eines hochfrequenten Signals gekoppelt ist.

7. Empfangsanordnung nach Anspruch 6 oder 7,
**dadurch gekennzeichnet, daß**
eine Steuerschaltung (23) vorgesehen ist, die an den Steuereingang (22) angeschlossen und ausgelegt ist zum Umschalten zwischen einem eingeschalteten Zustand (Φ1) und einem ausgeschalteten Zustand (Φ2) des Vorverstärkers (14) in Abhängigkeit vom Vorliegen eines Nutzsignals.

8. Empfangsanordnung nach einem der Ansprüche 1 bis 7,
**dadurch gekennzeichnet, daß**
ein Bandpaßfilter (19) vorgesehen ist mit einem Eingang, der mit dem Mittel zum Einkoppeln (21) eines hochfrequenten Signals (RF) gekoppelt ist, und mit einem Ausgang, der mit dem Signaleingang (5) an dem Transistor (1) des Vorverstärkers (14) gekoppelt ist.

## Claims

1. Reception arrangement having a preamplifier circuit comprising
- a means for coupling in (21) a radio-frequency signal,
- the preamplifier circuit (14), comprising a preamplifier (14) with a transistor (1), having a signal input (5) on the transistor (1) for the purpose of supplying a radio-frequency useful signal (RF), which signal input is coupled to the means for coupling in (21) a radio-frequency signal, a signal output on the transistor (1) for the purpose of providing an amplified signal derived from the useful signal, and a switch (17), with a first connection, which is connected to the signal input (5), with a second connection, which is connected to a reference potential connection (4), and with a control input for closing the switch (17) while the preamplifier (14) is in an inactive state (Φ2),
- a down-conversion frequency mixer (11) with a useful signal input which is coupled to the signal output of the preamplifier (14), with a local oscillator signal input and with an output (OUT) for tapping off a down-converted signal (BB), and
- a control input (22) which is coupled to the control input of the preamplifier for the purpose of closing the switch (17) between the signal input (5) of the transistor (1) and reference potential (4) when no useful signal is being received (Φ2).

2. Reception arrangement according to Claim 1,
**characterized in that**
the preamplifier (14) comprises, in addition to the transistor (1) which is in the form of a first transistor, a second transistor (2), which is coupled to the first transistor (1) in order to form a balanced amplifier and whose input connection (5') and output connection respectively form a balanced signal input (5, 5') and a balanced signal output with the signal input (5) and the signal output of the first transistor (1), and wherein,
in addition to the switch which is in the form of a first switch (17), there is a second switch (18), with a first connection, which is connected to the signal input (5') of the balanced amplifier, with a second connection, which is connected to the reference potential connection (4), and with a control input for the purpose of closing the second switch while the preamplifier (14) is in the inactive state (Φ2).

3. Reception arrangement according to Claim 1 or 2,
**characterized in that**
a means for activating (15) the preamplifier (14) is provided.

4. Reception arrangement according to one of Claims 1 to 3,
**characterized in that**
the signal input (5) of the transistor (1) is the latter's base or gate connection.

5. Reception arrangement according to Claims 3 and 4,
**characterized in that**
the means for activating (15) the preamplifier is in the form of a switch between the base and collector connections or between the gate and drain connections of the transistor (1).

6. Reception arrangement according to one of Claims 1 to 5,
**characterized in that**
there is a duplex unit (20), with an output which is coupled to the input of a bandpass filter (19), with an input to which a transmission path (Tx) for transmitting a radio-frequency signal is connected, and with a connection which is coupled to the means for coupling in (21) a radio-frequency signal.

7. Reception arrangement according to Claim 6 or 7,
**characterized in that**
there is a control circuit (23) which is connected to the control input (22) and is designed to change over between a turned-on state (Φ1) and a turned-off state (Φ2) for the preamplifier (14) on the basis of the presence of a useful signal.

8. Reception arrangement according to one of Claims 1 to 7,
**characterized in that**
there is a bandpass filter (19) with an input which is coupled to the means for coupling in (21) a radio-frequency signal (RF) and with an output which is coupled to the signal input (5) on the transistor (1) of the preamplifier (14).

## Revendications

1. Ensemble récepteur à circuit préamplificateur comprenant
- un moyen d'injection (21) d'un signal de haute fréquence,
- le circuit (14) préamplificateur comprenant un préamplificateur (14) ayant un transistor (1), ayant une entrée (5) de signal sur le transistor (1) pour l'accès d'un signal (RF), utile de haute fréquence, qui est couplé au moyen d'injection (21) d'un signal de haute fréquence, une sortie de signal sur le transistor (1) pour disposer d'un signal amplifié dérivé du signal utile et un interrupteur (17) ayant une première borne qui est raccordée à l'entrée (5) du signal, une deuxième borne qui est reliée à une borne (4) de potentiel de référence et une entrée de commande pour fermer l'interrupteur (17) pendant un état (ϕ2) inactif du préamplificateur (14),
- un mélangeur (11) de fréquence en aval, ayant une entrée de signal utile, qui est couplée à la sortie de signal du préamplificateur (14), une entrée de signal d'oscillateur local et une sortie (OUT) de prélèvement d'un signal (BB) mixte en aval et,
- une entrée (22) de commande, qui est couplée à l'entrée de commande du préamplificateur pour fermer l'interrupteur (17) entre l'entrée (15) de signal du transistor (1) et le potentiel (4) de référence lorsqu'un signal utile n'est pas reçu (ϕ2).

2. Ensemble de réception suivant la revendication 1,
**caractérisé en ce que**
le préamplificateur (14) comprend en plus du transistor (1) constitué en premier transistor, un deuxième transistor (2) qui, pour former un amplificateur symétrique, est couplé au premier transistor (1) et dont la borne (5') d'entrée et la borne de sortie forment respectivement avec l'entrée (5) du signal et la sortie du signal du premier transistor (1) une entrée (5, 5') de signal symétrique et une sortie de signal symétrique et **en ce qu'**en plus de l'interrupteur réalisé en tant que premier interrupteur (17), il est prévu un deuxième interrupteur (18) ayant une première borne qui est raccordée à l'entrée (5') de signal de l'amplificateur symétrique, une deuxième borne qui est reliée à la borne (4) du potentiel de référence et une entrée de commande pour fermer le deuxième interrupteur pendant l'état (ϕ2) inactif du préamplificateur (14).

3. Ensemble de réception suivant la revendication 1 ou 2,
**caractérisé en ce que**
il est prévu un moyen d'activation (15) du préamplificateur (14).

4. Ensemble de réception suivant l'une des revendications 1 à 3,
**caractérisé en ce que**
l'entrée (5) du signal du transistor (1) est sa borne de base ou sa borne de grille.

5. Ensemble de réception suivant la revendication 3 et 4,
**caractérisé en ce que**
le moyen d'activation (15) du préamplificateur est réalisé en tant qu'interrupteur entre la borne de base et de collecteur ou entre la borne de grille et de drain du transistor (1).

6. Ensemble de réception suivant l'une des revendications 1 à 5,
**caractérisé en ce que**
il est prévu une unité (20) duplex ayant une sortie qui est couplée à l'entrée d'un filtre (19) passe bande, une entrée à laquelle est raccordé un trajet (Tx) d'émission d'un signal de haute fréquence et une borne qui est couplée au moyen d'injection (21) d'un signal de haute fréquence.

7. Ensemble de réception suivant la revendication 6 ou 7,
**caractérisé en ce que**
il est prévu un circuit (23) de commande qui est raccordé à l'entrée (22) de commande et qui est conçu pour commuter entre un état (ϕ1) branché et un état (ϕ2) débranché du préamplificateur (14) en fonction de la présence d'un signal utile.

8. Ensemble de réception suivant l'une des revendications 1 à 7,
**caractérisé en ce que**
il est prévu un filtre (19) passe bande ayant une entrée qui est couplée au moyen d'injection (21) d'un signal (RF) de haute fréquence et une sortie qui est couplée à l'entrée (5) du signal sur le transistor (1) du préamplificateur (14).
